(19) Europäisches Patentamt
European Patent Office
Office européen des brevets

(11) Veröffentlichungsnummer: **0 152 377**
**B1**

(12) # EUROPÄISCHE PATENTSCHRIFT

(45) Veröffentlichungstag der Patentschrift: **09.12.87**

(51) Int. Cl.[4]: **C 08 G 85/00**, C 08 G 59/68

(21) Anmeldenummer: **85810040.7**

(22) Anmeldetag: **04.02.85**

(54) **Härtbare Zusammensetzung und deren Verwendung.**

(30) Priorität: **10.02.84 CH 632/84**
**07.09.84 CH 4286/84**

(43) Veröffentlichungstag der Anmeldung:
**21.08.85 Patentblatt 85/34**

(45) Bekanntmachung des Hinweises auf die Patenterteilung:
**09.12.87 Patentblatt 87/50**

(84) Benannte Vertragsstaaten:
**AT CH DE FR GB IT LI NL**

(56) Entgegenhaltungen:
**EP - A - 0 094 914**
**EP - A - 0 094 915**
**EP - A - 0 126 712**
**GB - A - 2 099 825**

**Die Akte enthält technische Angaben, die nach dem Eingang der Anmeldung eingereicht wurden und die nicht in dieser Patentschrift enthalten sind.**

(73) Patentinhaber: **CIBA-GEIGY AG, Klybeckstrasse 141, CH-4002 Basel (CH)**

(72) Erfinder: **Meier, Kurt, Dr., Ulmenstrasse 11, CH-4123 Allschwil (CH)**
Erfinder: **Zweifel, Hans, Dr., Leuengasse 4, CH-4057 Basel (CH)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



ACTORUM AG

**Beschreibung**

Die vorliegende Erfindung betrifft eine härtbare Zusammensetzung aus a) einem kationisch oder radikalisch polymerisierbaren Material, b) einem Eisen(II)-$\eta^6$-Benzol-$\eta^5$-Cyclopentadienyl-Komplexsalz, c) einem Sensibilisator für die Verbindungen b) und d) einem Elektronenacceptor als Oxidationsmittel für das radikalisch polymerisierbare Material, ein Verfahren zum Polymerisieren dieses Materials durch Strahlungseinwirkung, ein mit der Zusammensetzung beschichtetes Material und dessen Verwendung.

In der EP-A-0 094 915 ist eine härtbare Zusammensetzung aus einem kationisch polymerisierbaren Material beschrieben, das als Initiator ein ($\pi$-Aren)-metallkomplexsalz enthält. Die Zusammensetzung kann direkt thermisch gehärtet werden oder zuerst zur Aktivierung des Initiators bestrahlt und dann thermisch gehärtet werden. Für eine vollständige Aushärtung muss aber relativ lange belichtet werden, was unwirtschaftlich ist. Es besteht daher der Wunsch, die Lichtempfindlichkeit zu erhöhen. Es besteht ferner der Wunsch nach der Bestrahlung die thermische Härtung zu vermeiden und die Härtung nur durch Strahlung zu erzielen. Es wurde nun gefunden, dass man die Lichtempfindlichkeit wesentlich erhöhen kann, wenn man bei ausgewählten ($\pi$-Aren)metallkomplexsalzen gleichzeitig einen Sensibilisator mitverwendet. Weiter wurde gefunden, dass die thermische Härtung weitgehend vermieden werden kann, wenn man zusätzlich ein Oxidationsmittel mitverwendet.

Gegenstand vorliegender Erfindung ist eine Zusammensetzung, enthaltend

a) ein radikalisch oder kationisch polymerisierbares Material,

b) mindestens eine Eisenverbindung der Formel I

$$[(R^1)(R^2Fe^{II})_a]^{+a} \ \frac{a}{q} \ (LQ_m)^{-q} \qquad (I)$$

worin

a 1 oder 2 und q 1, 2 oder 3 sind,

L ein zweiwertiges bis siebenwertiges Metall oder Nichtmetall bedeutet,

Q für ein Halogenatom steht,

m eine ganze Zahl ist, die der Summe der Wertigkeit von L und q entspricht,

$R^1$ ein unsubstituiertes oder substituiertes $\eta^6$-Benzol und

$R^2$ ein unsubstituiertes oder substituiertes Cyclopentadienylanion bedeuten, und

c) mindestens einen Sensibilisator für die Verbindung der Formel I, wobei bei radikalisch polymerisierbaren Materialien zusätzlich (d) ein Elektronenacceptor als Oxidationsmittel zugegen ist.

Vorteilhaft enthält die Zusammensetzung mit einem kationisch härtbaren Material ebenfalls einen Elektronenacceptor als Oxidationsmittel, besonders bei der Verwendung zur Härtung durch Bestrahlung.

Die Eisenverbindung der Formel I oder die Eisenverbindung der Formel I und das Oxidationsmittel d) sind bevorzugt in einer Menge von 0,1-15 Gew.-%, besonders 0,1-10 Gew.-% und ganz besonders 0,1-5 Gew.-% zugegen. Das Gewichtsverhältnis der Eisenverbindung der Formel I zu dem Oxidationsmittel (d) beträgt bevorzugt 1 : 10 bis 5 : 1, besonders 1 : 1 bis 5 : 1. Der Sensibilisator (c) wird bevorzugt in einer Menge von 0,1-10 Gew.-%, besonders 0,1-5 Gew.-% und insbesondere 0,1-2,5 Gew.-% einverleibt.

$R^1$ in Formel I als einkerniges $\pi$-Aren von Benzol kann durch gleiche oder verschiedene Halogenatome, $C_1$-$C_{12}$-Alkyl-, $C_2$-$C_{12}$-Alkenyl, $C_2$-$C_{12}$-Alkinyl, $C_1$-$C_8$-Alkoxy-, Cyan-, $C_1$-$C_{12}$-Alkylthio, $C_2$-$C_6$-Monocarbonsäureester-, Phenyl-, $C_2$-$C_5$-Alkanoyl- oder Benzoylgruppen einfach oder mehrfach substituiert sein.

Das Cyclopentadienylanion $R^2$ kann durch gleiche oder verschiedene $C_1$-$C_8$-Alkyl-, $C_2$-$C_8$-Alkenyl-, $C_2$-$C_8$-Alkinyl-, $C_2$-$C_6$-Monocarbonsäureester-, Cyan-, $C_2$-$C_5$-Alkanoyl- oder Benzoylgruppen einfach oder mehrfach substituiert sein.

Die Alkyl-, Alkoxy-, Alkylthio-, Monocarbonsäurealkylester- und Alkanoylsubstituenten können dabei geradkettig oder verzweigt sein. Als typische Alkyl-, Alkoxy-, Alkylthio-, Monocarbonsäurealkylester- bzw. Alkanoylsubstituenten seien Methyl, Äthyl, n-Propyl, Isopropyl, n-Butyl, sek.-Butyl, tert.-Butyl, n-Pentyl, n-Hexyl und n-Octyl, Methoxy, Äthoxy, n-Propoxy, Isopropoxy, n-Butoxy, n-Hexyloxy und n-Octyloxy, Methylthio, Äthylthio, n-Propylthio, Isopropylthio, n-Butylthio, n-Pentylthio und n-Hexylthio, Carbonsäuremethyl-, -äthyl-, -n-propyl-, -isopropyl-, -n-butyl- und -n-pentylester bzw. Acetyl, Propionyl, Butyryl und Valeroyl genannt. Dabei sind Alkyl-, Alkoxy-, Alkylthio- und Monocarbonsäurealkylestergruppen mit 1 bis 4 und insbesondere 1 oder 2 Kohlenstoffatomen in den Alkylteilen sowie Alkanoylgruppen mit 2 oder 3 Kohlenstoffatomen bevorzugt. $R^1$ als substituiertes $\pi$-Aren des Benzols ist bevorzugt ein solches, das einen oder zwei der obengenannten Substituenten, insbesondere Chlor- oder Bromatome, Methyl-, Äthyl-, Propyl-, Isopropyl-, Methoxy-, Äthoxy-, Cyan-, Carbonsäuremethyl- oder -äthylestergruppen und Acetylgruppen, enthält.

Beispiele für geeignete $\pi$-Arene des Benzoles sind Benzol, Toluol, Xylole, Äthylbenzol, Methoxybenzol, Äthoxybenzol, Dimethoxybenzol, p-Chlortoluol, Chlorbenzol, Brombenzol, Dichlorbenzol, Acetylbenzol, Trimethylbenzol, Trimethoxybenzol, 1,2-Dihydronaphthalin, 1,2,3,4-Tetrahydronaphthalin, Mesitylen, Cumol, Diphenyl, Anisol und Dodecylbenzol. Bevorzugt sind Benzol, Toluol, Xylol, Cumol, Mesitylen, Chlorbenzol, Chlortoluol, Anisol, Dimethoxybenzol, Diphenyl, Dodecylbenzol oder Tetralin.

$R^2$ ist bevorzugt das Cyclopentadienylanion oder ein $C_1$-$C_4$-alkyliertes Cyclopentadienylanion, besonders das Methylcyclopentadienylanion.

In Formel I steht a bevorzugt für 1.

Beispiele für geeignete Metalle oder Nichtmetalle L sind Sb, Fe, Sn, Bi, Al, Ga, In, Ti, Zr, Sc, V, Cr, Mn und Cu; Lanthanide wie Ce, Pr, und Nd oder Actinide wie Th, Pa, U oder Np. Geeignete Nichtmetalle sind insbesondere B, P und As. L ist vorzugsweise P, As, B oder Sb, wobei P besonders bevorzugt wird. Q als Halogenatom ist bevorzugt Cl und besonders F.

In Formel I steht q bevorzugt für 1, m für 6, Q für F und L für B, P, As oder Sb.

Komplexe Anionen $[LQ_m]^{-q}$ sind beispielsweise $BF_4^-$, $PF_6^-$, $AsF_6^-$, $SbF_6^-$, $FeCl_4^-$, $SnCl_6^-$, $SbCl_6^-$ und $BiCl_6^-$. Die besonders bevorzugten komplexen Anionen sind $SbF_6^-$, $BF_4^-$, $AsF_6^-$ und $PF_6^-$.

Die Verbindungen der Formel I sind bekannt oder können nach analogen Verfahren hergestellt werden.

Bei den Elektronenacceptoren als Oxidationsmittel (d) handelt es sich bevorzugt um ein organische Hydroperoxid, eine organische Persäure oder ein Chinon.

Beispiele sind: Tertiärbutylhydroperoxid, Cumolhydroperoxid, Triphenylmethylhydroperoxid, Tetralinhydroperoxid, α-Methyltetralinhydroperoxid, Decalinhydroperoxid, Perbenzoesäure, m-Chlorobenzoesäure oder Benzochinon.

Geeignete Sensibilisatoren (c) sind z.B. solche, die eine Triplettenenergie von mindestens 125,6 (30), bevorzugt mindestens 146,5 (35) kJ/Mol (kcal/Mol) aufweisen. Sie können z.B. ausgewählt sein aus der Gruppe der mono- oder polycyclischen Kohlenwasserstoffaromaten oder Heteroaromaten, der Phenone, besonders der Acetophenone und der Benzophenone, der Benzile, der Stilbene, der Polyacetylene, der Xanthone und Thioxanthone, der Anthracene, der Phthalimide, besonders der Phthalimidthioäther, und der Dione mit benachbarten CO-Gruppen. Weitere geeignete Sensibilisatoren und Beispiele sind in S.L. Murov, Handbook of Photochemistry, M. Dekker Inc., New York, Seiten 27 ff (1973) erwähnt.

Bevorzugte Sensibilisatoren sind Thioxanthone, Phthalimide besonders Phthalimidthioäther, Cumarine und Anthracene. Geeignete Phthalimidthioäther sind in der DE-A-3 117 589 und EP-A 0 062 615 beschrieben. Geeignete Thioxanthone sind z.B. in der DE-A-3 018 891 und der EP 0 033 720 beschrieben.

Besonders bevorzugte Sensibilisatoren sind unsubstituiertes oder substituierte Anthracene, oder Gemische solcher Anthracene.

Sie können der Formel II

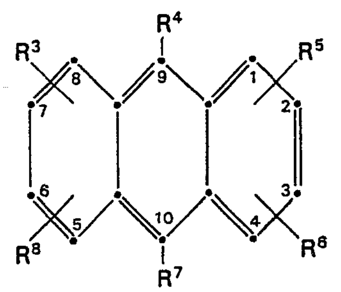

(II)

entsprechen, worin $R^3$ bis $R^8$ unabhängig voneinander ein Wasserstoffatom, Halogen, Cyano, lineares oder verzweigtes $C_1$-$C_{18}$-Alkyl, -Alkoxy oder -Alkylthio, unsubstituiertes oder mit $C_1$-$C_6$-Alkyl substituiertes $C_5$-$C_{12}$-Cycloalkyl, lineares oder verzweigtes $C_3$-$C_{18}$-Alkenyl, $C_7$-$C_{16}$-Aralkyl, $C_nH_{2n}$-CZ, $-C_nH_{2n}$-CN, $-C_nH_{2n}$-$COOR^9$ oder

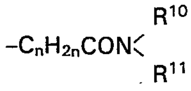

worin n eine Zahl von 1 bis 18, $R^9$ lineares oder verzweigtes $C_1$-$C_{18}$-Alkyl, unsubstituiertes oder mit $C_1$-$C_6$-Alkyl substiuiertes $C_5$-$C_{12}$-Cycloalkyl, $C_6$-$C_{12}$-Aryl, $C_7$-$C_{16}$-Alkaryl, $C_7$-$C_{16}$-Aralkyl, $C_8$-$C_{16}$-Alkaralkyl oder ein Metallkation, $R^{10}$ und $R^{11}$ unabhängig voneinander ein Wasserstoffatom, $C_1$-$C_{18}$-Alkyl, $C_5$-$C_{12}$-Cycloalkyl oder $R^{10}$ und $R^{11}$ zusammen Tetramethylen, Pentamethylen oder 3-Oxapentylen, und Z ein Wasserstoffatom oder $C_1$-$C_{18}$-Alkyl sind, bedeuten.

In einer bevorzugten Ausführungsform ist mindestens einer der Reste $R^3$ bis $R^8$ einer der zuvor definierten Substituenten. In einer anderen Ausführungsform sind $R^3$, $R^5$, $R^6$ und $R^8$ ein Wasserstoffatom und $R^4$ und/oder $R^5$ $C_1$-$C_{18}$-Alkyl oder $C_1$-$C_{18}$-Alkoxy. In einer weiteren bevorzugten Ausführungsform sind $R^4$ und $R^6$ bis $R^8$ ein Wasserstoffatom und $R^3$ und $R^5$ einer der zuvor definierten Substituenten, wobei $R^3$ insbesondere in 6- oder 7-Stellung und $R^5$ in 2-Stellung gebunden sind.

$R^3$ bis $R^8$ sind als Halogen bevorzugt Chlor und enthalten als Äthyl, Alkoxy und Alkylthio bevorzugt 1 bis 12, besonders 1-6 C-Atome und enthalten als Cycloalkyl 5 oder 6-Ringkohlenstoffatome. $R^3$ bis $R^8$ als Alkenyl enthalten bevorzugt 3 bis 8 C-Atome. $R^3$ bis $R^8$ als Aralkyl sind bevorzugt Phenylalkyl mit insbesondere 7 bis 12 C-Atomen.

Die Zahl n ist bevorzugt 1 bis 12 und besonders 1 bis 6. $R^9$ enthält als Alkyl bevorzugt 1 bis 12, besonders 1 bis 6 C-Atome und enthält als Cycloalkyl bevorzugt 5 oder 6 Ringkohlenstoffatome. $R^9$ als Aryl ist bevorzugt Phenyl, als Alkaryl bevorzugt $C_7$-$C_{12}$-Alkylphenyl, als Aralkyl bevorzugt $C_7$- bis $C_{12}$-Phenylalkyl und als Alkaralkyl bevorzugt $C_8$-$C_{12}$-Alkylphenylalkyl. $R^9$ als Metallkation ist bevorzugt ausgewählt aus der Alkali- und Erdalkalimetallgruppe, wie z.B. Mg, Ca, K und besonders Na.

$R^{10}$ und $R^{11}$ enthalten als Alkyl bevorzugt 1 bis 12, besonders 1 bis 6 C-Atome. Als Cycloalkyl enthalten $R^{10}$ und $R^{11}$ bevorzugt 5 oder 6 Ringkohlenstoffatome. Z enthält als Alkyl bevorzugt 1 bis 12, besonders 1 bis 6 C-Atome.

Beispiele für Alkyl, Alkoxy und Alkylthio sind: Methyl, Ethyl, n-Propyl, i-Propyl, n-Butyl, i-Butyl, t-Butyl, 1-, 2- oder 3-Pentyl, 1-, 2- oder 3-Hexyl, Heptyl, Octyl, Nonyl, Decyl, Undecyl, Dodecyl, Tetradecyl, Hexadecyl oder Octadecyl und entsprechende Alkoxy- und Alkylthioreste.

Beispiele für Cycloalkyl sind: Cyclopentyl, Methylcyclopentyl, Cyclohexyl, Methylcyclohexyl.

Beispiele für Alkenyl sind: Allyl und 1-Propenyl.

Beispiele für Aryl, Aralkyl, Alkaryl und Alkaralkyl sind: Phenyl, Benzyl, 2-Phenylethyl, Methylphenyl, Ethylphenyl und Methylbenzyl.

Die Verbindungen der Formel II sind teilweise bekannt. Neue Verbindungen der Formel II können nach bekannten Verfahren erhalten werden, z.B durch Friedl-Crafts-Alkylierungsreaktionen von Anthracen oder substituierten Anthracenen.

Beispiele sind: Perylen, 3,4-Benzopyren, 1,12-Benzperylen, Pyren, Pentaphen, 1,2-Benzopyren, Fluoranthren, 1,2-Benzochrysen, 1-Aminonaphthalin, Coronen, 1-Nitronaphthalin, 3,4-Benzofluoren, 2,2'-Binaphthyl, 1-Naphthaldehyd, 5,6-Benzochrysen, 1-Acetylnaphthalin, 3,4,5,6-Dibenzophenanthren, Chrysen, 1,2-und 2,3-Benzofluoren, 1-Benzoylnaphthalin, 1-Naphthonitril, Naphthalin-1-carbonsäure, 1,2,6,7-Dibenzopyren, 9-Acetyl-phenanthren, 1-Naphthol, 1-Jodonaphthalin, 2-Phenylnaphthalin, 3,4-Benzophenanthren, 3-Acetylphenanthren, 1-Bromnaphthalin, 1-Chlornaphthalin, 2-Naphthonitril, Acenaphthen, 2-Naphthaldehyd, Naphthalin-2-carbonsäure, 2-Acetylnaphthalin, 2-Benzoylnaphthalin, 1-Methylnaphthalin, 1-Methoxynaphthalin, 1-Fluornaphthalin, 2-Jodnaphthalin, 2-Bromnaphthalin, 2-Chlornaphthalin, 2-Naphthol, 2-Methylnaphthalin, Naphthalin, Phenanthren, Anthrachinon, Triphenylen, 4-Benzoylpyridin, 2-Benzoylpyridin, Fluoren, 3-Benzoylpyridin, Carbazol, 4-Acetylpyridin, 4-Methoxybenzaldehyd, 4-Methylbenzaldehyd, Benzaldehyd, Anthron, 1-Tetralon, 4-Phenylacetophenon, 3,4-Methylendioxyacetophenon, 4-Cyanoacetophenon, α-Chloracetophenon, 3,4,5-Trimethylacetophenon, 3,5-Dimethylacetophenon, 4-Bromacetophenon, 4-Methoxyacetophenon, 3,4-Dimethylacetophenon, Triphenylmethylacetophenon, 4-Chloracetophenon, 4-Trifluormethylacetophenon, 2,4,6-Trimethylacetophenon, 3-Methoxyacetophenon, 3-Methylacetophenon, 3-Bromacetophenon, 4-Methylacetophenon, 3-Cyanoacetophenon, 3-Trifluormethylacetophenon, Acetophenon, Allylacetophenon, Benzophenon, 4-Phenylbenzophenon, 4,4'-Bi-dimethylamino-benzophenon, 4-Cyanobenzophenon, 4,4'-Dichlorbenzophenon, 4-Trifluormethylbenzophenon, 3-Methoxybenzophenon, 4-Chlorbenzophenon, 3-Chlorbenzophenon, 4,4'-Dibrombenzophenon, 4-Methoxybenzophenon, 3,4-Dimethylbenzophenon, 4-Methylbenzophenon, 2-Methylbenzophenon, 4,4'-Dimethylbenzophenon, 2,5-Dimethylbenzophenon, 2,4-Dimethylbenzophenon, 4-Fluorbenzophenon, Orthobenzylbenzophenon, 4,4'-Dimethoxybenzophenon, 2-Phenylbutyrophenon, β-Phenylpriophenon, Propiophenon, Valerophenon, Butyrophenon, Benzil, Transstilben, Cisstilben, Diphenyltetraacetylen, Tetraacetylenglykol, Diäthyltetraacetylen, Diphenylacetylen, Xanthon, Thioxanthon, 2-Isopropylthioxanthon, 2-Chlorthioxanthon, 2-Dodecylthioxanthon, 1-Methoxycarbonylthioxanthon, 2-Äthoxycarbonylthioxanthon, 3-(n-Methoxyäthoxycarbonyl)thioxanthon, 4-Butoxycarbonylthioxanthon, 1-Cyano-3-chlorthioxanthon, 2-Äthoxycarbonyl-3-nitrothioxanthon, Anthracen, 1-Chloranthracen, 2-Methylanthracen, 9-Methylanthracen, 2-Tertiärbutylanthracen, 9-Methoxyanthracen, 9,10-Dimethoxyanthracen, 2,6- oder 2,7-Dimethylanthracen, 2-t-Butylanthracen, 2,6- oder 2,7-Di-t-butylanthracen, 2-(Methoxycarbonylmethyl)anthracen, 2-(5-Methoxycarbonyl-2-methyl-pent-2-yl)-anthracen, 2,6- oder 2,7-Di-(5-methoxycarbonyl-2-methyl-pent-2-yl)-anthracen, 1,2-Benzanthracen, 1,2,3,4-Dibenzanthracen, 1,2,5,6-Dibenzoanthracen, 1,2,7,8-Dibenzoanthracen, 3-Thiophenylphthalimid, N-Methyl-4-thiophenylphthalimid, 2,3-Butandion.

Für die erfindungsgemässen härtbaren Zusammensetzungen geeignete, kationisch polymerisierbare organische Materialien sind beispielsweise solche der folgenden Arten, wobei diese für sich allein oder als Gemische von mindestens zwei Komponenten eingesetzt werden können:

I. Äthylenisch ungesättigte Verbindungen, die nach einem kationischen Mechanismus polymerisierbar sind. Dazu gehören

1. Mono- und Diolefine, z.B. Isobutylen, Butadien, Isopren, Styrol, α-Methylstyrol, Divinylbenzole, N-Vinylpyrrolidon, N-Vinylcarbazol und Acrolein.

2. Vinyläther, z.B. Methylvinyläther, Isobutylvinyläther, Trimethylolpropantrivinyläther, Äthylenglykoldivinyläther; cyclische Vinyläther, z.B. 3,4-Dihydro-2-formyl-2H-pyran (dimeres Acrolein) und der 3,4-Dihydro-2H-pyran-2-carbonsäureester des 2-Hydroxymethyl-3,4-dihydro-2H-pyrans.

3. Vinylester, z.B. Vinylacetat und Vinylstearat.

II. Kationisch polymerisierbare heterocyclische Verbindungen, z.B. Äthylenoxid, Propylenoxyd, Epichlorhydrin, Glycidyläther einwertiger Alkohole oder Phenole, z.B. n-Butylglycidyläther, n-Octylglycidyläther, Phenylglycidyläther und Kresylglycidyläther; Glycidylacrylat, Glycidylmethacrylat, Styroloxyd und Cyclohexenoxyd; Oxetane wie 3,3-Dimethyloxetan und 3,3-Di-(chlormethyl)-oxetan; Tetrahydrofuran; Dioxolane, Trioxan und 1,3,6-Trioxacyclooctan; Lactone wie β-Propiolacton, γ-Valerolacton und ε-Caprolacton; Thiirane wie Äthylensulfid und Propylensulfid; Azetidine wie N-Acylazetidine, z.B. N-Benzoylazetidin sowie die Addukte von Azetidin mit Diisocyanaten, z.B. Toluylen-2,4- und -2,6-diisocyanat und 4,4'-Diaminodiphenylmethandiisocyanat; Epoxiharze; lineare und verzweigte Polymere mit Glycidylgruppen in den Seitenketten, z.B. Homo- und Copolymere von Polyacrylat- und Polymethacrylat-glycidyl-estern.

Besonders wichtige unter diesen obengenannten polymerisierbaren Verbindungen sind die Epoxidharze und insbesondere die Di- und Polyepoxide und Epoxidharzpräpolymere der zur Herstellung vernetzter Epoxiharze verwendeten Art. Die Di- und Polyepoxide können aliphatische, cycloaliphatische oder aromatische Verbindungen sein. Beispiele für solche Verbindungen sind die Glycidyläther und β-Methylglycidyläther aliphatischer oder cycloaliphatischer Diole oder Polyole, zum Beispiel solche des Äthylenglykols, Propan-1,2-diols, Propan-1,3-diols, Butan-1,4-diols, Diäthylenglykols, Polyäthylenglykols, Polypropylenglykols, Glycerins, Trimethylolpropans oder 1,4-Dimethylolcyclohexans oder des 2,2-Bis-(4-hydroxycyclohexyl)-propans und N,N-Bis-(2-hydroxyäthyl)-anilins; die Glycidyläther von Di- und Polyphenolen, beispielsweise Resorcin, 4,4'-Dihydroxydiphenylmethan, 4,4'-Dihydroxydiphenyl-2,2-propan, Novolake und 1,1,2,2-Tetrakis-(4-hydroxyphenyl)-äthan. Weitere Beispiele sind N-Glycidylverbindungen, z.B. die Diglycidylverbindungen des Äthylenharnstoffs, 1,3-Propylenharnstoffs oder 5-Dimethylhydantoins oder des 4,4'-Methylen-5,5'-tetramethyl-dihydantoins, oder solche wie Triglycidylisocyanurat.

Weitere Glycidylverbindungen mit technischer Bedeutung sind die Glycidylester von Carbonsäuren, insbesondere Di- und Polycarbonsäuren. Beispiele dafür sind die Glycidylester der Bersteinsäure, Adipin-säure, Azelainsäure, Sebacinsäure, Phthalsäure, Terephthalsäure, Tetra- und Hexahydrophthalsäure, Isophthalsäure oder Trimellithsäure, oder von dimerisierten Fettsäuren.

Beispiele für von Glycidylverbindungen verschiedene Polyepoxide sind die Diepoxide des Vinylcyclohexens und Dicyclopentadiens, 3-(3',4'-Epoxicyclohexyl)-8,9-epoxy-2,4-dioxaspiro[5.5]undecan, der 3',4'-Epoxicyclohexylmethylester der 3,4-Epoxicyclohexancarbonsäure, Butadiendiepoxid oder Isoprendiepoxid, epoxidierte Linolsäurederivate oder epoxidiertes Polybutadien.

Bevorzugte Epoxidharze sind gegebenenfalls vorverlängerte Diglycidyläther zweiwertiger Phenole oder zweiwertiger aliphatischer Alkohole mit 2 bis 4 Kohlenstoffatomen, Besonders bevorzugt werden die gegebenenfalls vorverlängerten Diglycidyläther des 2,2-Bis-(4-hydroxyphenyl)-propans und Bis-(4-hydroxyphenyl)-methans.

Als kationische polymerisierbare Verbindungen kommen ferner in Betracht:

III. Methylolverbindungen:

1. Aminoplaste wie die N-Hydroxymethyl-, N-Methoxymethyl-, N-n-Butoxymethyl- und N-Acetoxymethylderivate von Amiden oder amidartigen Verbindungen, z.B. cyclischen Harnstoffen wie Äthylenharnstoff (Imidazolidin-2-on), Hydantoin, Uron (Tetrahydro-oxadiazin-4-on), 1,2-Propylenharnstoff (4-Methylimidazolidin-2-on), 1,3-Propylenharnstoff (Hexahydro-2H-pyrimid-2-on), Hydroxypropylenharnstoff (5-Hydroxyhexahydro-2H-pyrimid-2-on), 1,3,5-Melamin und weitere Polytriazine wie Acetoguanamin, Benzoguanamin und Adipoguanamin.

Gewünschtenfalls kann man Aminoplaste einsetzen, die sowohl N-Hydroxymethyl- als auch N-Alkoxymethyl- oder sowohl N-Hydroxymethyl- als auch N-Acetoxymethylgruppen enthalten (beispielsweise ein Hexamethylolmelamin, in dem 1 bis 3 der Hydroxylgruppen mit Methylgruppen veräthert sind).

Als Aminoplaste werden die Kondensationsprodukte von Harnstoff, Uron, Hydantoin oder Melamin mit Formaldehyd sowie teilweise oder völlig verätherte Produkte solcher Kondensationsprodukte mit einem aliphatischen einwertigen Alkohol mit 1 bis 4 Kohlenstoffatomen bevorzugt.

2. Phenolplaste.

Bevorzugte Phenolplaste sind aus einem Phenol und einem Aldehyd hergestellte Resole. Zu geeigneten Phenolen gehören Phenol selbst, Resorcin, 2,2-Bis-(p-hydroxyphenyl)-propan, p-Chlorphenol, ein durch eine oder zwei Alkylgruppen mit je 1 bis 9 Kohlenstoffatomen substituiertes Phenol, wie o-, m- und p-Kresol, die Xylenole, p-tert.-Butylphenol und p-Nonylphenol sowie auch phenylsubstituierte Phenole, insbesondere p-Phenylphenol. Der mit dem Phenol kondensierte Aldehyd ist vorzugsweise Formaldehyd, doch kommen auch andere Aldehyde wie Acetaldehyd und Furfurol in Frage. Gewünschtenfalls kann man ein Gemisch solcher härtbarer Phenol/Aldehydharze verwenden.

Die bevorzugten Resole sind Kondensationsprodukte des Phenols, p-Chlorphenols, Resorcins oder o-, m- oder p-Kresols mit Formaldehyd.

Geeignete radikalisch polymerisierbare organische Materialien sind besonders mono- oder polyäthylenisch ungesättigte Verbindungen. Beispiele sind: Styrol, Vinylpyridin, Vinylacetat, Divinylbenzol, Vinyläther, Acrylamid, Methacrylamid, Bisacrylamid, Bismethacrylamid, ungesättigte Polyester, insbesondere auf der Basis von Maleinsäure. Bevorzugte Materialien sind die Ester oder Amide von Acrylsäure und/oder Methacrylsäure von linearen oder verzweigten Alkoholen, Polyolen bzw. Mono- oder Polyaminen. Bei den Polyolen und Polyaminen können auch Teilester vorliegen.

Beispiele für Polyamine sind Äthylen-, Propylen-, Butylen-, Hexylendiamin, Phenylendiamin, Benzylendiamin, Naphthylendiamin, Diäthylentriamin, Triäthylentetramin, Diaminoäthyläther. Beispiele für Polyole sind lineare und verzweigte Alkylendiole wie Äthylen-, Propylen-, Butylen-, Pentylen-, Hexylen-, Octylendiol, Polyoxaalkylendiole wie Diäthylen- und Triäthylenglykol und Polyäthylenglykole mit einem Molekulargewicht von 200 bis 500, 1,4-Dihydroxycyclohexan, 1,4-Di(hydroxymethyl)-cyclohexan, Dihydroxybenzole Hydroxymethylphenole, Triole wie 1,2,3-Trihydroxypropan, 1,2,4-Trihydroxybutan, Trimethylolpropan, Pentaerythrit, Dipentaerythrit und niedermolekulare Polyester mit Hydroxylendgruppen.

Geeignete Alkohole und Monoamine sind z.B. Methanol, Äthanol, Propanol, Butanol, Pentanol, Hexanol, Heptanol, Octanol, 2-Äthylhexanol, Cyclohexanol, Phenol, Glycidol, Methylamin, Dimethylamin, Äthylamin.

Bevorzugte radikalisch polymerisierbare organische Materialien sind Teilester von Epoxidharzen und Acrylsäure, Methacrylsäure oder einer Mischung dieser Säuren sowie Acrylsäure- und/oder Methacrylsäureester von Polyolen.

Die erfindungsgemässen härtbaren Zusammensetzungen lassen sich z.B. als homogene flüssige Gemische oder in homogener oder inhomogener glasiger Form erhalten. Homogene glasige Produkte können in an sich bekannter Weise zum Beispiel durch Verflüssigung fester polymerisierbarer organischer Materialien, gegebenenfalls unter Zusatz geeigneter Lösungsmittel im Dunkeln oder unter rotem Licht, Erhitzen auf Temperaturen über ihrem Glasübergangspunkt, Zugabe der Komponenten b) und c) und gegebenenfalls (d) und Abkühlung der entstandenen Gemische erhalten werden. Gewünschtenfalls kann man die so erhaltenen glasigen Produkte anschliessend zerkleinern. Inhomogene glasige Produkte können beispielsweise durch Vermischen glasiger polymerisierbarer Materialien in Pulverform mit den Komponenten b) und c) und gegebenenfalls d) erhalten werden.

Die erfindungsgemässen Zusammensetzungen sind bei Raumtemperatur unter Gelblichtbedingungen, stabil und somit lagerfähig. Sie können direkt heissgehärtet werden, zweckmässig bei Temperaturen, die nahe bei dem Schmelzpunkt oder Zersetzungspunkt der Komponenten b) und c) und gegebenenfalls d) liegen. Sie weisen eine hohe Lichtempfindlichkeit auf bei gleichzeitiger Gelblichtstabilität bei solchen Sensibilisatoren, die Licht im Bereich unter 400 nm absorbieren.

Ein wesentlicher Vorteil der erfindungsgemässen Zusammensetzung, die die Komponente d) enthält, ist, dass sie durch Einwirkung von Strahlung gehärtet werden kann, wobei die vollständige Aushärtung im allgemeinen durch die gebildete Reaktionswärme erfolgt und sich ein äusseres Erwärmen erübrigt. Es kann aber manchmal zweckmässig sein, zusätzlich

eine äussere Erwärmung nach dem Belichten vorzunehmen, z.B. wenn kürzere Reaktionszeiten gewünscht sind.

Ein weiterer Gegenstand vorliegender Erfindung ist somit ein Verfahren zum Polymerisieren eines radikalisch oder kationisch polymerisierbaren organischen Materials unter Einwirkung von Strahlung in Gegenwart eines Photoinitiators und gegebenenfalls unter Erwärmen, das dadurch gekennzeichnet ist, dass der Photoinitiator eine Mischung aus

a) mindestens einer Eisenverbindung der Formel I

$$[(R^1)(R^2Fe^{II})_a]^{+a} \frac{a}{q} (LQ_m)^{-q} \qquad (I)$$

worin

a 1 oder 2 und q 1, 2 oder 3 sind,

L ein zweiwertiges bis siebenwertiges Metall oder Nichtmetall bedeutet,

Q für ein Halogenatom steht,

m eine ganze Zahl ist, die der Summe der Wertigkeit von L und q entspricht,

$R^1$ ein unsubstituiertes oder substituiertes $\eta^6$-Benzol und $R^2$ ein unsubstituiertes oder substituiertes Cyclopentadienylanion bedeuten,

b) mindestens einem Sensibilisator für Verbindung der Formel I und

c) mindestens einem Elektronenacceptor als Oxidationsmittel, ist, und dass man gegebenenfalls danach die Polymerisationsreaktion durch Wärmezufuhr vervollständigt.

Die Bestrahlung dieser härtbaren Gemische erfolgt zweckmässig mit Elektronenstrahlen oder aktinischem Licht, vorzugsweise einer Wellenlänge von 200 bis 600 nm und einer Intensität von 150 bis 5000 Watt. Als Lichtquellen eignen sich beispielsweise Xenonlampen, Argonlampen, Wolframlampen, Kohlelichtbögen, Metallhalogenid- und Metalllichtbogenlampen, wie Niederdruck-, Mitteldruck- und Hochdruckquecksilberlampen. Vorzugsweise wird die Bestrahlung mit Metallhalogenid- oder Hochdruckquecksilberlampen durchgeführt. Die Bestrahlungszeit hängt von verschiedenen Faktoren ab, einschliesslich z.B. dem polymerisierbaren organischen Material, der Art der Lichtquelle und deren Abstand vom bestrahlten Material. Die Bestrahlungszeit beträgt vorzugsweise 10 bis 60 Sekunden.

Das Erwärmen der belichteten Zusammensetzungen kann in herkömmlichen Konvektionsöfen stattfinden. Sind kurze Erhitzungs- oder Reaktionszeiten erforderlich, so kann das Erhitzen durch Belichtung mit beispielsweise IR-Strahlung, IR-Lasern oder Mikrowellengeräten erfolgen. Die Polymerisationstemperaturen liegen im Bereich von Raumtemperatur bis etwa 80°C.

Die erfindungsgemässen Zusammensetzungen können auch weitere, bekannte und üblicherweise in der Technik photopolymerisierbarer Materialien eingesetzte Zusatzstoffe enthalten. Beispiele für solche Zusatzstoffe sind Pigmente, Farbstoffe, Füllstoffe und Verstärkungsmittel, Glasfasern und sonstige Fasern, Flammhemmstoffe, Antistatika, Verlaufmittel, Antioxydantien und Lichtschutzmittel, sowie herkömmliche Photoinitiatoren wie Acetophenone, Acylphosphinoxyde oder aromatische Ketone. Um die Endeigenschaften von Epoxidharzen zu verbessern, kann man polyfunktionelle Hydroxylverbindungen, zum Beispiel wie in der deutschen Offenlegungsschrift 2 639 395 beschrieben, einarbeiten.

Zur Erhöhung der Lagerfähigkeit im Dunkeln können die härtbaren Zusammensetzungen schwache organische Basen wie Nitrile, Amide, Lactone oder Harnstoffderivate enthalten. Um vorzeitige Reaktion durch unbeabsichtigte Belichtung zu vermeiden, kann man kleine Mengen UV-Absorptionsmittel und/oder organische Farbstoffe zusetzen.

Die erfindungsgemässe Zusammensetzung kann nach üblichen Methoden auf mindestens eine Oberfläche eines Trägermaterials aufgebracht werden. Das beschichtete Material ist ebenfalls ein Gegenstand der Erfindung. Geeignete Träger sind z.B. Metalle und Halbmetalle wie Stahl, Aluminium, Kupfer, Cadmium, Zink, Silicium, sowie Keramik, Glas, Kunststoffe, Papier und Holz. Das beschichtete Material kann zur Herstellung von Schutzschichten und Passivierschichten durch Belichtung verwendet werden, was ein weiterer Gegenstand der Erfindung ist.

Wird bei der Belichtung nur ein Teil der Beschichtung durch eine Photomaske bstrahlt, so können die unbelichteten Stellen anschliessend mit einem geeigneten Lösungsmittel entfernt werden. Das beschichtete Material eignet sich somit auch als photographisches Aufzeichnungsmaterial, zur Herstellung von Druckplatten und besonders gedruckten Schaltungen sowie als Lötstopplack. Die Verwendung als photographisches Aufzeichnungsmaterial ist ebenfalls ein Gegenstand vorliegender Erfindung

Die erfindungsgemässen Zusammensetzungen mit einem kationisch polymerisierbaren Material, die keine Oxidationsmitttel d) enthalten, können nach Verfahren gehärtet werden, die in der EP-A-0094915 beschrieben sind. Diese Zusammensetzungen können direkt heissgehärtet werden. Bevorzugter ist eine Zweistufenpolymerisation, bei der durch Bestrahlung zunächst der Eisenkomplex der Formel I aktiviert wird, und man die so erhaltenen aktivierten Vorstufen dann heisshärtet, z.B. bei Temperaturen von etwa 50 bis 120°C. Wird die Bestrahlung durch eine Photomaske vorgenommen, können photographische Abbildungen erzeugt werden. Die Bestrahlungszeit liegt etwa zwischen 5 und 60 Sekunden, und die Zeit für die Heisshärtung etwa zwischen 30 Sekunden und 5 Minuten. Diese erfindungsgemässen Zusammensetzungen zeichnen sich durch eine hohe Lichtempfindlichkeit aus.

Die erfindungsgemässen Zusammensetzungen sind auch als Klebstoffe oder zur Herstellung von Kitten, Füllstoffen oder faserverstärkten Verbundstoffen und Schichtkörpern verwendbar.

Die erfindungsgemässen Zusammensetzungen weisen eine hohe Lichtempfindlichkeit auf, was zudem für die Aushärtung kurze Belichtungszeiten bedeutet. Gleichzeitig werden kationisch und radikalisch wirksame Initiatoren bei der Belichtung erzeugt, was den Anwendungsbereich bezüglich der polymerisierbaren Materialien erweitert. Es überrascht hierbei, dass das Oxidationsmittel erst nach der Belichtung wirksam wird und eine Härtung durch Bestrahlung ermöglicht. Es ist sehr vorteilhaft, dass die Aushärtung im allgemeinen durch die Einwirkung von Strahlung ohne äussere Wärmezufuhr erfolgt.

Die nachfolgenden Beispiele erläutern die Erfindung näher.

*Beispiel a*

($\eta^6$-Toluol)($\eta^5$-cyclopentadienyl)-eisen(II)-hexafluorophosphat wird gemäss Bull. Soc. Chim. France, 2572 (1975) hergestellt.

*Beispiel b*

($\eta^6$-Anisol)($\eta^5$-cyclopentadienyl)-eisen(II)-hexafluorophosphat wird gemäss Dokl. Akad. SSSR, 175, 609 (1967) hergestellt.

*Beispiel c*

($\eta^6$-p-Dimethoxybenzol)($\eta^5$-cyclopentadienyl)-eisen(II)-tetrafluoroborat wird gemäss J. Chem. Soc. C. 116 (1969) hergestellt.

*Beispiel d*

($\eta^6$-p-Chlorotoluol)($\eta^5$-cyclopentadienyl)-eisen(II)-hexafluorophosphat wird gemäss J. Organomet. Chem. 20, 169 (1969) hergestellt.

*Beispiel e*

($\eta^6$-Isopropylbenzol)($\eta^5$-cyclopentadienyl)-eisen-(II)-hexafluorophosphat wird gemäss R.C. Acad. Sc. Paris, Ser C., 272, 1337 (1971) hergestellt.

*Beispiel f*

($\eta^6$-Isopropylbenzol)($\eta^5$-cyclopentadienyl)-eisen-(II)-hexafluoroantimonat, wird gemäss Beispiel e, jedoch unter Verwendung von Kaliumhexafluoroantimonat hergestellt.

*Beispiel g*

($\eta^6$-Isopropylbenzol)($\eta^5$-cyclopentadienyl)-eisen-(II)-hexafluoroarsenat wird gemäss Beispiel e, jedoch unter Verwendung von Kaliumhexafluoroarsenat hergestellt.

*Beispiel h*

($\eta^6$-Biphenyl)($\eta^5$-cyclopentadienyl)-eisen(II)-hexafluorophosphat wird gemäss J. Chem. Soc. Chem. Comm. 907 (1972) hergestellt.

*Beispiel i*

($\eta^6$-Tetralin)($\eta^5$-cyclopentadienyl)-eisen(II)-hexafluorophosphat wird gemäss J. Organomet. Chem. 101, 221 (1975) hergestellt.

*Anwendungsbeispiel*

*Beispiel 1*

Eine Lösung bestehend aus 10 g eines technischen Epoxidkresolnovolak (Epoxidgehalt 4,5 Äq/kg), 0,25 g ($7 \times 10^{-4}$ Mol) ($\eta^6$-Toluol)($\eta^5$-cyclopentadienyl)-eisen(II)-hexafluorophosphat (hergestellt gemäss Beispiel a), 0,25 g ($1,3 \times 10^{-3}$ Mol) 9-Methylanthracen und 4 g 1-Acetoxy-2-ethoxyethan wird mit einem 25 nm Drahtrakel auf eine kupferkaschierte Epoxidplatte aufgebracht. Der vorerst nasse Film wird bei 80°C getrocknet (Trockenfilmldicke ca. 15 nm). Die Belichtung der so hergestellten Photopolymerplatte erfolgt mit einer 5000-Watt Quecksilberhochdrucklampe, Abstand zum Probentisch 50 cm, wobei als Vorlage ein 21 step Stouffer sensitivity guide verwendet wird (s. W.S. DeForest, Photoresist, McGraw-Hill Book Comp., N.Y., S. 109 ff). Die Belichtungszeit beträgt 30 s, danach wird die belichtete Platte während 2 Minuten bei 110°C gehärtet. Die Entwicklung erfolgt in 1-Acetoxy-2-ethoxyethan, wobei die nicht belichteten Anteile gelöst werden. Es resultiert ein Reliefbild, mit der letzten abgebildeten Stufe No. 5.

*Beispiel 2 bis 14*

Es wird unter Verwendung verschiedener Initiatoren und Sensibilisatoren wie in Beispiel 1 verfahren.

In Tabelle 1 sind die Ergebnisse zusammengefasst. Der Initiatorgehalt (Aren-Ferrocenium-Komplex) beträgt immer 2,5 Gewichtsprozente, bezogen auf den Epoxikresolnovolak, die jeweilige Sensibilisatorkonzentration immer 1,3 mMol, bezogen auf den Epoxikresolnovolak. Es wird je 10, 20 und 30 Sekunden lang belichtet.

Tabelle 1

| Beispiel Nr. | Initiator (gemäss Beispiel Nr.) | Sensibilisator | Letzte abgebildete Stufe nach Belichtungszeit von 10 | 20 | 30 sec. |
|---|---|---|---|---|---|
| 1 | a | 9-Methylanthracen | 2 | 4 | 5 |
| 2 | a | 2-Methylanthracen | 3 | 4 | 6 |
| 3 | b | 9-Methylanthracen | 3 | 4 | 6 |
| 4 | c | 9-Methylanthracen | 3 | 4 | 6 |
| 5 | d | 9,10-Diethoxyanthracen | 3 | 5 | 6 |
| 6 | e | 2-Methylanthracen | 2 | 4 | 6 |
| 7 | f | 2-Methylanthracen | 12 | 14 | 16 |
| 8 | g | 2-Methylanthracen | 9 | 11 | 14 |
| 9 | h | 9,10-Diethoxyanthracen | 3 | 5 | 6 |
| 10 | i | 9-Methylanthracen | 2 | 4 | 5 |
| 11 | a | 2,6-Di-t-butylanthracen | 2 | 4 | 5 |
| 12 | a | 2,7-Di-t-butylanthracen | 2 | 3 | 5 |
| 13 | a | 2,6-Di-(5-methoxycarbonyl-2-methyl-pent-2-yl)-anthracen | 3 | 4 | 6 |
| 14 | a | 2,7-Di-(5-methoxycarbonyl-2-methyl-pent-2-yl)-anthracen | 3 | 4 | 6 |

**Patentansprüche**

1. Zusammensetzung, enthaltend

a) ein radikalisch oder kationisch polymerisierbares Material,

b) mindestens eine Eisenverbindung der Formel I

$$[(R^1)(R^2Fe^{II})_a]^{+a}\ \frac{a}{q}\ (LQ_m)^{-q} \qquad (I)$$

worin

a 1 oder 2 und q 1, 2 oder 3 sind,

L ein zweiwertiges bis siebenwertiges Metall oder Nichtmetall bedeutet,

Q für ein Halogenatom steht,

m eine ganze Zahl ist, die der Summe der Wertigkeit von L und q entspricht,

$R^1$ ein unsubstituiertes oder substituiertes $\eta^6$-Benzol und

$R^2$ ein unsubstituiertes oder substituiertes Cyclopentadienylanion bedeuten, und

c) mindestens einen Sensibilisator für die Verbindung der Formel I, wobei bei radikalisch polymerisierbaren Materialien zusätzlich (d) ein Elektronenacceptor als Oxidationsmittel zugegen ist.

2. Zusammensetzung gemäss Anspruch 1, dadurch gekennzeichnet, dass auch für das kationisch polymerisierbare Material ein Elektronenacceptor als Oxidationsmittel zugegen ist.

3. Zusammensetzung gemäss Anspruch 1 oder 2, dadurch gekennzeichnet, dass die Eisenverbindung (b) oder die Eisenverbindung (b) und das Oxidationsmittel (d) in einer Menge von 0,1 bis 15 Gew.-% zugegen sind, bezogen auf die Komponente (a).

4. Zusammensetzung gemäss Anspruch 3, dadurch gekennzeichnet, dass das Gewichtsverhältnis der Eisenverbindung (b) zu dem Oxidationsmittel (d) von 1 : 10 bis 5 : 1 beträgt.

5. Zusammensetzung gemäss Anspruch 1, dadurch gekennzeichnet, dass der Sensibilisator (c) in einer Menge von 0,1 bis 10 Gew.-% vorhanden ist, bezogen auf die Komponente (a).

6. Zusammensetzung gemäss Anspruch 1, dadurch gekennzeichnet, dass $R^1$ durch gleiche oder verschiedene Halogenatome, $C_1$-$C_{12}$-Alkyl-, $C_2$-$C_{12}$-Alkenyl, $C_2$-$C_{12}$-Alkinyl, $C_1$-$C_8$-Alkoxy-, Cyan-, $C_1$-$C_8$-Alkylthio-, $C_2$-$C_6$-Monocarbonsäureester-, Phenyl-, $C_2$-$C_5$-Alkanoyl- oder Benzoylgruppen einfach oder mehrfach substituiert ist.

7. Zusammensetzung gemäss Anspruch 1, dadurch gekennzeichnet, dass $R^2$ durch gleiche oder verschiedene $C_1$-$C_8$-Alkyl-, $C_2$-$C_8$-Alkenyl-, $C_2$-$C_8$-Alkinyl-, $C_2$-$C_6$-Monocarbonsäureester-, Cyan-, $C_2$-$C_5$-Alkanoyl- oder Benzoylgruppen einfach oder mehrfach substituiert ist.

8. Zusammensetzung gemäss Anspruch 1, dadurch gekennzeichnet, dass a in Formel I für 1 steht.

9. Zusammensetzung gemäss Anspruch 1, dadurch gekennzeichnet, dass in Formel I m für 6, L für B, P, As oder Sb, Q für F und q für 1 stehen.

10. Zusammensetzung gemäss Anspruch 1, dadurch gekennzeichnet, dass in Formel I $R^1$ für Benzol, Toluol, Xylol, Cumol, Mesitylen, Chlorbenzol, Chlortoluol, Anisol, Dimethoxybenzol, Diphenyl, Dodecylbenzol oder Tetralin steht.

11. Zusammensetzung gemäss Anspruch 1, dadurch gekennzeichnet, dass in Formel I $R^2$ das Cyclopentadienyl- oder Methylcyclopentadienylanion bedeutet.

12. Zusammensetzung gemäss Anspruch 1, dadurch gekennzeichnet, dass das Oxidationsmittel (d) ein organisches Hydroperoxid, eine organische Persäure oder ein Chinon ist.

13. Zusammensetzung gemäss Anspruch 12, dadurch gekennzeichnet, dass das Oxidationsmittel Tertiärbutylhydroperoxid, Cumolhydroperoxid, Triphenylmethylhydroperoxid, Tetralinhydroperoxid, α-Methyltetralinhydroperoxid, Decalinhydroperoxid, Perbenzoesäure, m-Chlorbenzoesäure oder Benzochinon ist.

14. Zusammensetzung gemäss Anspruch 1, dadurch gekennzeichnet, dass der Sensibilisator (c) ausgewählt ist aus der Gruppe der mono- oder polycyclischen Kohlenwasserstoffaromaten oder Heteroaromaten, der Phenone, besonders der Acetophenone und der Benzophenone, der Benzile, der Stilbene, der Polyacetylene, der Xanthone und Thioxanthone, der Anthracene, der Phthalimide, besonders der Phthalimidthioäther und der Dione mit benachbarten CO-Gruppen.

15. Zusammensetzung gemäss Anspruch 14, dadurch gekennzeichnet, dass der Sensibilisator (c) ein Thioxanthon, ein Phthalimid, ein Cumarin und besonders ein Anthracen ist.

16. Zusammensetzung nach Anspruch 1, dadurch gekennzeichnet, dass das kationisch polymerisierbare organische Material ein Epoxidharz ist.

17. Zusammensetzung nach Anspruch 1, dadurch gekennzeichnet, dass das radikalisch polymerisierbare Material eine mono- oder polyäthylenisch ungesättigte Verbindung ist.

18. Zusammensetzung gemäss Anspruch 17, dadurch gekennzeichnet, dass das radikalisch polymerisierbare Material ein Teilester eines Epoxidharzes und Acrylsäure, Methacrylsäure oder einer Mischung der Säuren ist oder ein Acrylsäureester oder Methacrylsäureester eines Polyols ist.

19. Beschichtetes Material, dadurch gekennzeichnet, dass auf einem Träger mindestens auf einer Oberfläche eine Schicht der Zusammensetzung gemäss Anspruch 1 aufgebracht ist.

20. Verwendung des Materials gemäss Anspruch 19 zur Herstellung von Schutzüberzügen und als photographisches Aufzeichnungsmaterial.

21. Verfahren zum Polymerisieren eines radikalisch oder kationisch polymerisierbaren Materials unter Einwirkung von Strahlung in Gegenwart eines Photoinitiators und gegebenenfalls unter Erwärmen, dadurch gekennzeichnet, dass der Photoinitiator eine Mischung aus

a) mindestens einer Eisenverbindung der Formel I

$$[(R^1)(R^2Fe^{II})_a]^{+a}\ \frac{a}{q}\ (LQ_m)^{-q} \qquad (I)$$

worin

a 1 oder 2 und q 1, 2 oder 3 sind,

L ein zweiwertiges bis siebenwertiges Metall oder Nichtmetall bedeutet,

Q für ein Halogenatom steht,

m eine ganze Zahl ist, die der Summe der Wertigkeit von L und q entspricht,

$R^1$ ein unsubstituiertes oder substituiertes $\eta^6$-Benzol und $R^2$ ein unsubstituiertes oder substituiertes Cyclopentadienylanion bedeuten,

b) mindestens einem Sensibilisator für Verbindung der Formel I und

c) mindestens einem Elektronenacceptor als Oxidationsmittel für das radikalisch polymerisierbare Material, ist.

## Claims

1. A composition containing:

a) a material polymerizable by free radical or cationic polymerization,

b) at least one iron compound of the formula I

$$[(R^1)(R^2Fe^{II})_a]^{+a} \frac{a}{q} (LQ_m)^{-q} \quad (I)$$

wherein

a is 1 or 2 and q is 1, 2 or 3,

L is a divalent to heptavalent metal or non-metal,

Q is a halogen atom,

m is an integer corresponding to the sum of the values of L and q,

$R^1$ is an unsubstituted or substituted $\eta^6$-benzene and

$R^2$ is an unsubstituted or substituted cyclopentadienyl anion, and

c) at least one sensitizer for the compound of the formula I, and, in the case of materials polymerizable by free radical polymerization, also d) an electron acceptor as an oxidizing agent.

2. A composition according to claim 1, wherein an electron acceptor is also present as an oxidizing agent for the material polymerizable by cationic polymerization.

3. A composition according to claim 1 or 2, wherein the iron compound b), or the iron compound b) and the oxidizing agent d), are present in a quantity of 0.1 to 15% by weight based on component a).

4. A composition according to claim 3, wherein the weight ratio of the iron compound b) to the oxidizing agent d) is from 1 : 10 to 5 : 1.

5. A composition according to claim 1, wherein the sensitizer c) is present in a quantity of 0.1 to 10% by weight based on component a).

6. A composition according to claim 1, wherein $R^1$ is monosubstituted or polysubstituted by identical or different halogen atoms or $C_1$-$C_{12}$-alkyl, $C_2$-$C_{12}$-alkenyl, $C_2$-$C_{12}$-alkynyl, $C_1$-$C_8$-alkoxy, cyano, $C_1$-$C_8$-alkylthio, $C_2$-$C_6$-monocarboxylic acid ester, phenyl, $C_2$-$C_5$-alkanoyl or benzoyl groups.

7. A composition according to claim 1, wherein $R^2$ is monosubstituted or polysubstituted by identical or different $C_1$-$C_8$-alkyl, $C_2$-$C_8$-alkenyl, $C_2$-$C_8$-alkynyl, $C_2$-$C_6$-monocarboxylic acid ester, cyano, $C_2$-$C_5$-alkanoyl or benzoyl groups.

8. A composition according to claim 1, wherein a is 1 in the formula I.

9. A composition according to claim 1, wherein m is 6, L is B, P, As or Sb, Q is F and q is 1 in the formula I.

10. A composition according to claim 1, wherein $R^1$ is benzene, toluene, xylene, cumene, mesitylene, chlorobenzene, chlorotoluene, anisole, dimethoxybenzene, biphenyl, dodecylbenzene or tetralin in the formula I.

11. A composition according to claim 1, wherein $R^2$ is the cyclopentadienyl or methylcyclopentadienyl anion in the formula I.

12. A composition according to claim 1, wherein the oxidizing agent d) is an organic hydroperoxide, an organic peracid or a quinone.

13. A composition according to claim 12, wherein the oxidizing agent is tertiary butyl hydroperoxide, cumene hydroperoxide, triphenylmethyl hydroperoxide, tetralin hydroperoxide, α-methyltetralin hydroperoxide, decalin hydroperoxide, perbenzoic acid, m-chloroperbenzoic acid or benzoquinone.

14. A composition according to claim 1, wherein the sensitizer c) is selected from the group consisting of the monocyclic or polycyclic hydrocarbon aromatics or heteroaromatics, the phenones, particularly the acetophenones and the benzophenones, the benzils, the stilbenes, the polyacetylenes, the xanthones and thioxanthones, the anthracenes, the phthalimides, particularly the phthalimide thioethers, and the diones with adjacent CO groups.

15. A composition according to claim 14, wherein the sensitizer c) is a thioxanthone, a phthalimide, a coumarin and particularly an anthracene.

16. A composition according to claim 1, wherein the organic material polymerizable by cationic polymerization is an epoxy resin.

17. A composition according to claim 1, wherein the material polymerizable by free radical polymerization is a monoethylenically or polyethylenically unsaturated compound.

18. A composition according to claim 1, wherein the material polymerizable by free radical polymerization is a partial ester of an epoxy resin and acrylic acid, methacrylic acid or a mixture of the acids, or an acrylic acid ester or methacrylic acid ester of a polyol.

19. A coated material, wherein a layer of the composition according to claim 1 is applied to at least one surface of a substrate.

20. Use of the material according to claim 19 for the production of protective coatings and as a photographic recording material.

21. A process for the polymerization of a material polymerizable by free radical or cationic polymerization, under the action of radiation, in the presence of a photoinitiator and, if appropriate, with heating, wherein the photoinitiator is a mixture of

a) at least one iron compound of the formula I

$$[(R^1)(R^2Fe^{II})_a]^{+a} \frac{a}{q} (LQ_m)^{-q} \quad (I)$$

wherein

a is 1 or 2 and q is 1, 2 or 3,

L is a divalent to heptavalent metal or non-metal,

Q is a halogen atom,

m is an integer corresponding to the sum of the values of L and q,

$R^1$ is an unsubstituted or substituted $\eta^6$-benzene and

$R^2$ is an unsubstituted or substituted cyclopentadienyl anion,

b) at least one sensitizer for the compounds of the formula I, and

c) at least one electron acceptor as an oxidizing agent for the material polymerizable by free radical polymerization.

## Revendications

1. Composition qui contient:

a) une matière polymérisable par voie radicalaire ou cationique.

b) au moins un composé du fer répondant à la formule I:

$$[(R^1)(R^2Fe^{II})_a]^{+a} \ \frac{a}{q} \ (LQ_m)^{-q} \qquad (I)$$

dans laquelle:

a est égal à 1 ou à 2,

q est égal à 1, à 2 ou à 3,

L représente un métal ou un non-métal dont la valence peut aller de 2 à 7,

Q représente un atome d'halogène,

m représente un nombre entier qui est égal à la somme de la valence de L et de q,

$R^1$ représente un $\eta^6$-benzène substitué ou non, et

$R^2$ représente un anion cyclopentadiényle substitué ou non,

c) au moins un sensibilisateur pour le composé de formule I, et, das le cas de matières polymérisables par voie radicalaire,

d) un accepteur d'électrons en tant qu'oxydant.

2. Composition selon la revendication 1, caractérisée en ce qu'elle contient également, pour la matière polymérisable par voie cationique, un accepteur d'électrons comme oxydant.

3. Composition selon l'une des revendications 1 et 2, caractérisée en ce que le composé du fer (b) ou le composé du fer (b) et l'oxydant (d) sont présents en une quantité de 0,1 à 15% en poids par rapport à la composante (a).

4. Composition selon la revendication 3, caractérisée en ce que le rapport pondéral du composé du fer (b) à l'oxydant (d) est compris entre 1 : 10 et 5 : 1.

5. Composition selon la revendication 1, caractérisée en ce que le sensibilisateur (c) est présent en une quantité de 0,1 à 10% en poids par rapport à la composante (a).

6. Composition selon la revendication 1, caractérisée en ce que $R^1$ porte un substituant ou plusieurs substituants, identiques ou différents, pris dans l'ensemble constitué par les atomes d'halogènes, les alkyles en $C_1$-$C_{12}$, les alcényles en $C_2$-$C_{12}$, les alcynyles en $C_2$-$C_{12}$, les alcoxy en $C_1$-$C_8$, le cyano, les alkylthio en $C_1$-$C_8$, les radicaux d'esters d'acides monocarboxyliques en $C_2$-$C_6$, le phényle, les alcanoyles en $C_2$-$C_5$ et le benzoyle.

7. Composition selon la revendication 1, caractérisée en ce que $R^2$ porte un substituant ou plusieurs substituants, identiques ou différents, pris dans l'ensemble constitué par les alkyles en $C_1$-$C_8$, les alcényles en $C_2$-$C_8$, les alcynyles en $C_2$-$C_8$, les radicaux d'esters d'acides monocarboxyliques en $C_2$-$C_6$, le cyano, les alcanoyles en $C_2$-$C_5$ et le benzoyle.

8. Composition selon la revendication 1, caractérisée en ce que l'indice a, dans la formule I, représente le nombre 1.

9. Composition selon la revendication 1, caractérisée en ce que, dans la formule I, m est égal à 6, L représente B, P, As ou Sb, Q représente F, et q est égal à 1.

10. Composition selon la revendication 1, caractérisée en ce que, dans la formule I, $R^1$ représente le benzène, le toluène, le xylène, le cumène, le mésitylene, le chlorobenzène, le chlorotoluène, l'anisole, le diméthoxybenzène, le biphényle, le dodécylbenzène ou la tétraline.

11. Composition selon la revendication 1, caractérisée en ce que, dans la formule I, $R^2$ représente l'anion cyclopentadiényle ou l'anion-cyclopentadiényle.

12. Composition selon la revendication 1, caractérisée en ce que l'oxydant (d) est un hydroperoxyde organique, un peracide organique ou une quinone.

13. Composition selon la revendication 12, caractérisée en ce que l'oxydant est l'hydroperoxyde de tert-butyle, l'hydroperoxyde de cumène, l'hydroperoxyde de triphénylméthyle, l'hydroperoxyde de tétraline, l'hydroperoxyde d'α-méthyltétraline, l'hydroperoxyde de décaline, l'acide perbenzoïque, l'acide m-chloro-perbenzoïque ou la benzoquinone.

14. Composition selon la revendication 1, caractérisée en ce que le sensibilisateur (c) est choisi dans l'ensemble constitué par les hydrocarbures aromatiques et les composés aromatiques hétérocycliques comportant un ou plusieurs cycles, les phénones, en particulier les acétophénones et les benzophénones, les benziles, les stilbènes, les polyacétylènes, les xanthones et thioxanthones, les anthracènes, les phtalimides, en particulier les thioéthers phtalimidiques, et les diones à radicaux -CO- voisins.

15. Composition selon la revendication 14, caractérisée en ce que le sensibilisateur (c) est une thioxanthone, une phtalimide, une coumarine ou, mieux, un anthracène.

16. Composition selon la revendication 1, caractérisée en ce que la matière organique polymérisable par voie cationique est une résine époxidique.

17. Composition selon la revendication 1, caractérisée en ce que la matière polymérisable par voie radicalaire est un composé monoéthylénique ou polyéthylénique.

18. Composition selon la revendication 17, caractérisée en ce que la matière polymérisable par voie radicalaire est un ester partiel formé par une résine époxydique et l'acide acrylique, l'acide méthacrylique ou un mélange de ces acides, ou est un ester acrylique ou méthacrylique d'un polyol.

19. Matière revêtue caractérisée en ce qu'une couche de la composition selon la revendication 1 est appliquée sur au moins une surface d'un support.

20. Application de la matière selon la revendication 19 pour la réalisation de revêtements protecteurs et comme matières d'enregistrement photographique.

21. Procédé pour polymériser une matière polymérisable par voie radicalaire ou cationique, sous l'action d'un rayonnement, en présence d'un photo-amorceur et, éventuellement, avec chauffage, procédé caractérisé en ce que le photo-amorceur est un mélange constitué:

a) d'au moins un composé du fer répondant à la formule I:

$$[(R^1)(R^2Fe^{II})_a]^{+a} \frac{a}{q} (LQ_m)^{-q} \quad (I)$$

dans laquelle:

a représente un nombre égal à 1 ou à 2,

q représente un nombre égal à 1, à 2 ou à 3,

L représente un métal ou un non-métal dont la valence peut aller de 2 à 7,

Q représente un atome d'halogène,

m désigne un nombre entier qui est égal à la somme de la valence de L et de q,

$R^1$ représente un $\eta^6$-benzène substitué ou non, et

$R^2$ représente un anion cyclopentadiényle substitué ou non,

b) d'au moins un sensibilisateur pour les composés de formule I, et

c) d'au moins un accepteur d'électrons comme oxydant pour la matière polymérisable par voie radicalaire.